# EUROPEAN PATENT APPLICATION

(11) **EP 4 769 089 A1**
(43) Date of publication of application: **01.07.2026**
(21) Application number: 25180094.2
(22) Date of filing: 02.06.2025
(51) Int. Cl.: G06F 3/041, G06F 3/044, H10K 59/40

(54) **DISPLAY APPARATUS**

(30) Priority: 26.12.2024 KR 20240197515
(71) Applicant: LG Display Co., Ltd., Seoul, 07336 (KR)
(72) Inventor: Ko, Intae, 10845 Paju-si (KR); Lee, Jin-Uk, 10845 Paju-si (KR); Oh, ChangSeok, 10845 Paju-si (KR)
(74) Representative: Cousens, Nico

(57) **Abstract**

A display apparatus according to the present disclosure comprises a display panel including a plurality of driving electrodes and a plurality of sensing electrodes intersecting the plurality of driving electrodes, and a plurality of touch drivers which is disposed on one side of the display panel and is electrically connected to the plurality of driving electrodes and the plurality of sensing electrodes, wherein the display panel includes a plurality of driving signal lines which connects the plurality of driving electrodes and the plurality of touch drivers, a plurality of sensing signal lines which connects the plurality of sensing electrodes and the plurality of touch drivers, and a plurality of compensation patterns which overlaps the plurality of driving signal lines and extends from the plurality of sensing signal lines.

## Description

### CROSS-REFERENCE TO RELATED APPLICATIONS

This application claims the priority of Korean Patent Application No. 10-2024-0197515 filed on December 26, 2024, in the Korean Intellectual Property Office.

### TECHNICAL FIELD

The present disclosure relates to a display apparatus, and more particularly, to a display apparatus having an irregular structure.

### BACKGROUND

As display apparatus which are used for a monitor of a computer, a television, or a cellular phone, there are an organic light emitting display (OLED) apparatus which is a self-emitting apparatus and a liquid crystal display (LCD) apparatus which requires a separate light source.

An applicable range of the display apparatus is diversified to personal digital assistants as well as monitors of computers and televisions and a display apparatus with a large display area and a reduced volume and weight is being studied. Further, studies on display apparatus having various shapes are being conducted and specifically, in recent years, studies on a display apparatus with an irregular structure are being conducted.

### SUMMARY

An object to be achieved by the present disclosure is to provide a display apparatus which reduces a touch RC load deviation in a display apparatus having an irregular structure.

Another object to be achieved by the present disclosure is to provide a display apparatus in which a compensation pattern which compensates for a touch RC load deviation is disposed so as to overlap a touch signal line to reduce a non-active area.

Objects of the present disclosure are not limited to the above-mentioned objects, and other objects, which are not mentioned above, can be clearly understood by those skilled in the art from the following descriptions.

According to an aspect of the present disclosure, a display apparatus comprises a display panel including a plurality of driving electrodes and a plurality of sensing electrodes intersecting the plurality of driving electrodes, and a plurality of touch drivers which is disposed on one side of the display panel and is electrically connected to the plurality of driving electrodes and the plurality of sensing electrodes, wherein the display panel includes a plurality of driving signal lines which connects the plurality of driving electrodes and the plurality of touch drivers, a plurality of sensing signal lines which connects the plurality of sensing electrodes and the plurality of touch drivers, and a plurality of compensation patterns which overlaps the plurality of driving signal lines and extends from the plurality of sensing signal lines.

According to another aspect of the present disclosure, a display apparatus comprises a display panel including an active area in which a distance between a top and a bottom varies in every area and a non-active area disposed on one side of the active area, a plurality of flexible circuit films disposed in the non-active area, a plurality of driving electrodes and a plurality of sensing electrodes intersect each other on the display panel, a plurality of touch drivers which is disposed in the non-active area and is electrically connected to the plurality of driving electrodes and the plurality of sensing electrodes, a plurality of driving signal lines which connects the plurality of driving electrodes and the plurality of touch drivers, a plurality of sensing signal lines which connects the plurality of sensing electrodes and the plurality of touch drivers, and a plurality of compensation patterns which overlaps the plurality of driving signal lines in the non-active area and extends from the plurality of sensing signal lines.

Other detailed matters of the exemplary embodiments are included in the detailed description and the drawings.

According to the present disclosure, a touch RC load deviation can is reduced in a display apparatus having an irregular structure.

According to the present disclosure, a compensation pattern which compensates for a touch RC load deviation of the display apparatus is disposed at a touch driver side to optimize touch performance.

The effects according to the present disclosure are not limited to the contents exemplified above, and more various effects are included in the present specification.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a schematic plan view of a display apparatus according to an exemplary embodiment of the present disclosure;
FIG. 2 is an enlarged plan view of an area X of FIG. 1;
FIG. 3 is a cross-sectional view of A-A' of FIG. 2;
FIG. 4 is a schematic enlarged plan view of a display apparatus according to another exemplary embodiment of the present disclosure; and
FIG. 5 is a schematic enlarged plan view of a display apparatus according to still another exemplary embodiment of the present disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, various exemplary embodiments of the present disclosure will be described in detail with reference to the accompanying drawings.

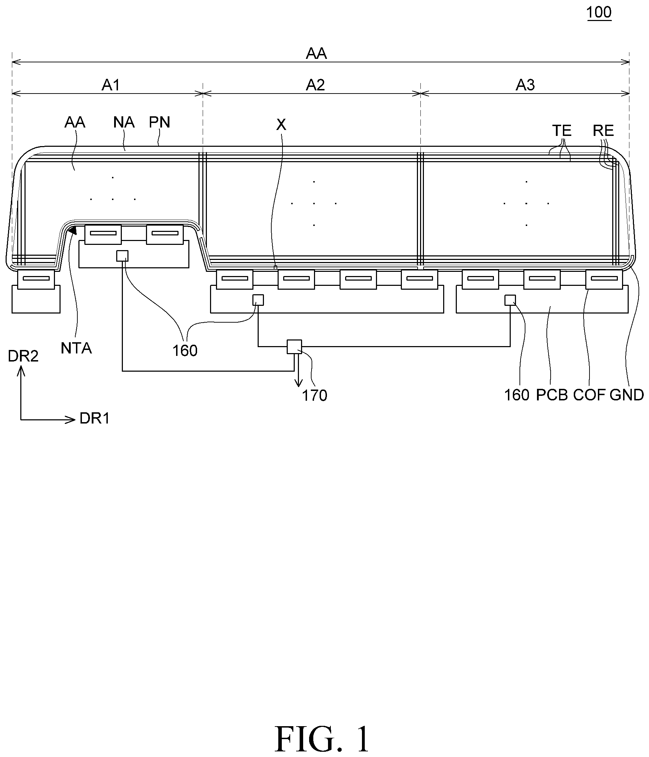

FIG. 1 is a schematic plan view of a display apparatus according to an exemplary embodiment of the present disclosure. Referring to FIG. 1, the display apparatus 100 includes a display panel PN, a plurality of flexible films COF, and a plurality of printed circuit board PCB.

Referring to FIG. 1, the display panel PN may include an irregularly shaped side. For example, the display panel PN may include a side formed by a straight line and a side formed by a curved line. Accordingly, a width of the display panel PN in a first direction DR1 may not constant, but may gradually reduce toward an upper direction and/or a lower direction of the display panel PN. Further, a width of the display panel PN in a second direction DR2 may not constant. The second direction DR2 may be perpendicular to the first direction DR1.

Further, a partial area of the display panel PN may have a shape which is inwardly concave toward the upper direction of the display panel PN more than the other area of the display panel PN. For example, the display panel PN may include at least one or more notch area NTA.

In the notch area NTA of the display panel PN, a configuration required to manipulate a vehicle, such as a vehicle steering wheel, may be disposed. That is, in the present disclosure, the display panel PN may be applied to the vehicle, but is not limited thereto.

In the display panel PN, an active area AA and a non-active area NA enclosing the active area AA may be defined. The active area AA is an area in which an image is actually displayed in the display apparatus 100 and a light emitting diode to be described below and various driving elements for driving the light emitting diode may be disposed in the active area AA. The non-active area NA is an area where images are not displayed so that the non-active area NA may be defined as an area enclosing the active area AA. Various components for driving a plurality of sub pixels disposed in the active area AA may be disposed in the non-active area NA.

The active area AA is an area where images are displayed. In the active area AA, a plurality of sub pixels including light emitting diodes and driving circuits may be disposed to display images.

The active area AA may include an irregular side corresponding to an outer periphery of the display panel PN. For example, in the first direction DR1, the width of the active area AA may be gradually reduced toward an upper direction and/or a lower direction of the active area AA. Further, a width of the active area AA in the second direction DR2 may not constant. Further, the active area AA may include an area which is upwardly concaved so as to correspond to the notch area NTA of the display panel PN.

The active area AA includes a first area A1, a second area A2, and a third area A3. The first area A1, the second area A2, and the third area A3 may be sequentially disposed along the first direction DR1.

Areas of the first area A1, the second area A2, and the third area A3 may be different from each other. For example, the area of the first area A1 may be smaller than the area of the second area A2 and the area of the third area A3.

Specifically, in the second direction DR2, a maximum width of the first area A1, a maximum width of the second area A2, and a maximum width of the third area A3 may be the same. However, in the first direction DR1, the maximum width of the first area A1 may be different from the maximum width of the second area A2 and the maximum width of the third area A3. For example, in the first direction DR1, the maximum width of the second area A2 and the maximum width of the third area A3 may be the same, but are smaller than the maximum width of the first area A1. Further, the first area A1 may include an area which is concave toward the top of the display panel PN so as to correspond to the notch area NTA. Accordingly, a bottom of the first area A1 corresponding to the notch area NTA may be disposed to be adjacent to the top of the display panel PN, more than a bottom of the first area A1 disposed on both sides of the notch area NTA.

In the meantime, when the display apparatus 100 is applied to the vehicle, the first area A1 may be disposed in front of a driver, the second area A2 may be disposed in an area between the driver and a passenger, and the third area A3 may be disposed in front of a front passenger seat.

In the active area AA, a plurality of driving electrodes TE and a plurality of sensing electrodes RE may be disposed. For example, the plurality of driving electrodes TE may receive a touch driving signal and the plurality of sensing electrodes RE may transmit a touch sensing signal corresponding to the touch driving signal.

The plurality of driving electrodes TE and the plurality of sensing electrodes RE may intersect. For example, the plurality of driving electrodes TE may extend in the first direction DR1 and the plurality of sensing electrodes RE may extend in the second direction DR2. In the meantime, the plurality of driving electrodes TE and the plurality of sensing electrodes RE may be connected through a bridge electrode. Specifically, the plurality of driving electrodes TE disposed in the first direction DR1 may be connected through the bridge electrode. Further, the plurality of sensing electrodes RE disposed in the second direction DR2 may be connected through the bridge electrode. At this time, the plurality of driving electrodes TE and the plurality of sensing electrodes RE are formed on the same layer, but are not limited thereto.

In the meantime, if the display apparatus 100 is a display apparatus including an organic light emitting diode, the display apparatus 100 may include an encapsulation layer which is located above the organic light emitting diode to seal the organic light emitting diode. At this time, the plurality of driving electrodes TE and the plurality of sensing electrodes RE may be located above the encapsulation layer, but are not limited thereto.

The non-active area NA is an area where no image is displayed and various wiring lines and drivers for driving the sub pixels disposed in the active area AA are disposed.

For example, the plurality of touch lines may be disposed in the non-active area NA. The plurality of touch lines is disposed between the touch driver 160 and the active area AA to electrically connect the touch driver 160 and the plurality of driving electrodes TE and the plurality of sensing electrodes RE. For example, the plurality of touch lines may include a plurality of driving signal lines which connects the plurality of driving electrodes TE and the plurality of touch drivers 160 and a plurality of sensing signal lines which connects the plurality of sensing electrodes RE and the plurality of drivers 160.

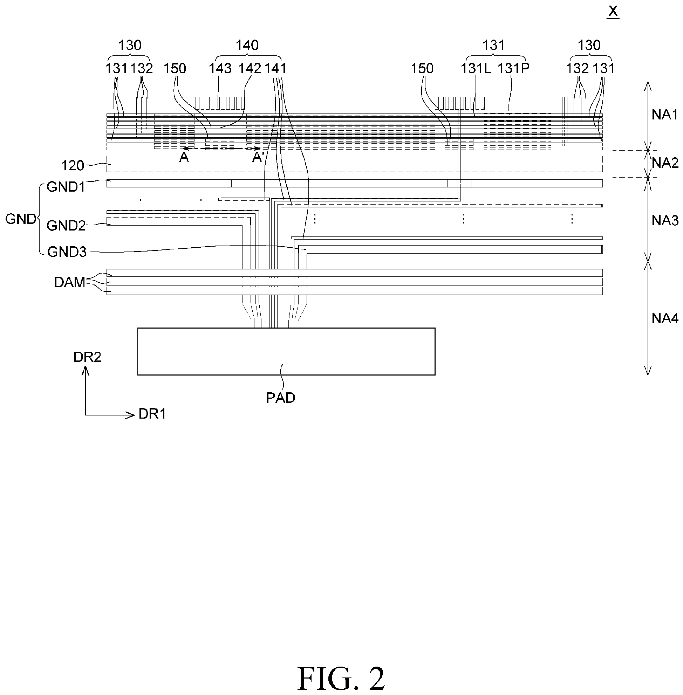

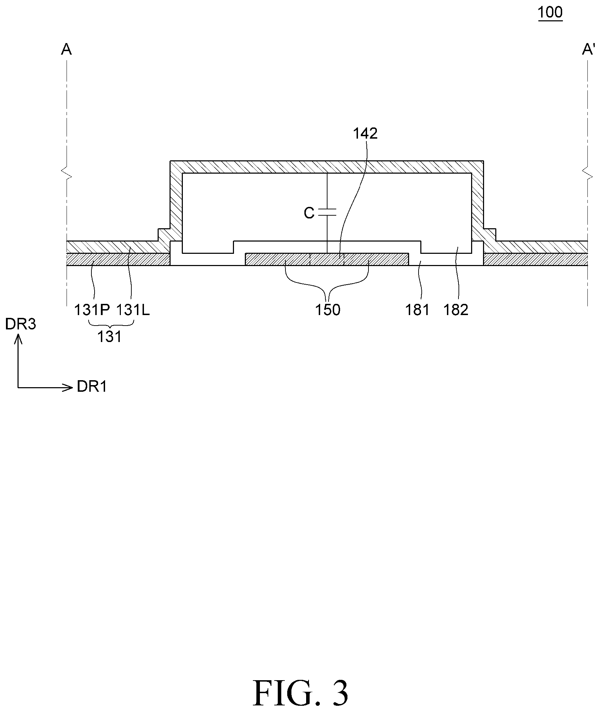

The plurality of driving signal lines and the plurality of sensing signal lines will be described in detail below with reference to FIGS. 2 and 3.

In the non-active area NA, a plurality of ground lines GND is disposed. The plurality of ground lines GND serves to discharge static electricity generated in the display apparatus 100.

The plurality of ground lines GND may be disposed so as to enclose the plurality of touch lines disposed in the non-active area NA. For example, the plurality of ground lines GND may have a closed-loop shape which encloses the plurality of driving signal lines and the plurality of sensing signal lines in the non-active area NA disposed between the touch driver 160 and the active area AA.

In the meantime, one ground line GND may be disposed so as to correspond to each touch driver 160. For example, when the touch driver 160 is disposed in each of the first area A1, the second area A2, and the third area A3 as illustrated in FIG. 1, one closed-loop shape ground line GND may be disposed in each of the first area A1, the second area A2, and the third area A3. That is, one ground line GND encloses a plurality of touch lines disposed in the first area A1, another ground line GND encloses a plurality of touch lines disposed in the second area A2, and the third ground line GND encloses a plurality of touch lines disposed in the third area A3.

Even though it is not illustrated in FIG. 1, a pad unit may be disposed in the non-active area NA of the display panel PN. The pad unit may be electrically connected to the plurality of flexible films COF and the plurality of printed circuit boards PCB to receive a data driving signal or exchange a touch signal with the external power source. Various driving signals, such as a data driving signal and a touch signal, may be supplied to the data driver and the touch driver, through the pad unit.

The pad unit of the display apparatus 100 according to the exemplary embodiment of the present disclosure may include a plurality of driving touch pad units and a plurality of sensing touch pad units. The plurality of driving touch pad units and the plurality of sensing touch pad units may be electrically connected to the plurality of touch drivers 160 through the plurality of flexible films COF.

A plurality of flexible films COF is connected to one side of the display panel PN so as to correspond to the plurality of pad units. The plurality of flexible films COF is films in which various components are disposed on a base film having malleability to supply a signal to the plurality of sub pixels of the active area AA. The plurality of flexible films COF is disposed on one side of the non-active area NA of the display panel PN to supply a data voltage and a touch signal to the active area AA.

The plurality of flexible films COF may be disposed below the active area AA. Therefore, a bezel above the display panel PN in which the plurality of flexible films COF is not disposed may be narrower than a bezel below the display panel PN in which the plurality of flexible films COF is disposed. In the meantime, shapes and a number of the plurality of flexible films COF illustrated in FIG. 1 are illustrative and the shapes and the number of the flexible films COF may be changed in various forms depending on the design, but are not limited thereto.

In the plurality of flexible films COF, a driver such as a gate driver and a data driver may be disposed. In the meantime, the gate driver is formed on a side surface of the active area AA in a gate driver in panel (GIP) manner, but is not limited thereto. The driver may be disposed by a chip on glass (COG), a chip on film (COF), or a tape carrier package (TCP) technique depending on a mounting method, but is not limited thereto.

The plurality of printed circuit boards PCB is connected to the plurality of flexible films COF. The plurality of printed circuit boards PCB is components which supply signals to the driving IC. Various components may be disposed in the plurality of printed circuit boards PCB to supply various driving signals, such as a driving signal or a data voltage to the driving IC.

Each of the plurality of printed circuit boards PCB may include the touch driver 160. The touch driver 160 may be electrically connected to the plurality of driving electrodes **TE** and the plurality of sensing electrodes RE disposed in the active area AA. For example, the touch driver 160 drives a plurality of driving electrodes TE and senses the plurality of sensing electrodes RE to generate and output touch sensing data. For example, the touch driver 160 may sense the touch by using mutual capacitance between the plurality of driving electrodes TE and the plurality of sensing electrodes RE. Therefore, the touch driver 160 may sense the change in the capacitance to detect a touch position.

The touch driver 160 may include a first touch driver, a second touch driver, and a third touch driver. The first touch driver applies a touch signal to the plurality of driving electrodes TE disposed in the first area A1 and senses the plurality of sensing electrodes RE. The second touch driver applies a touch signal to the plurality of driving electrodes TE disposed in the second area A2 and senses the plurality of sensing electrodes RE. The third touch driver applies a touch signal to the plurality of driving electrodes TE disposed in the third area A3 and senses the plurality of sensing electrodes RE. For example, the first touch driver may be electrically connected to the plurality of driving signal lines and the plurality of sensing signal lines disposed in the first area A1. The second touch driver may be electrically connected to the plurality of driving signal lines and the plurality of sensing signal lines disposed in the second area A2. The third touch driver may be electrically connected to the plurality of driving signal lines and the plurality of sensing signal lines disposed in the third area A3. Therefore, loads of the plurality of sensing electrodes RE and loads of the plurality of driving electrodes TE disposed in the active area AA are dispersed to the plurality of touch drivers 160 so that the load applied to each of the touch driver 160 may be reduced.

The plurality of touch drivers 160 may be connected to a touch controller 170. The touch controller 170 senses generation of a touch or detects touch information, such as a touch position, using touch sensing data. For example, the touch controller 170 transmits and receives data through the touch driver 160 and a plurality of communication lines. For example, the touch controller 170 and the touch driver 160 may use a serial peripheral interface (SPI) manner as a communication method to transmit and receive data. At this time, in the communication interface between the touch controller 170 and the touch driver 160, the touch controller 170 and the touch driver 160 may operate in a master-slave mode. That is, the touch driver 160 may operate as a slave and the touch controller 170 may operate as a master.

Hereinafter, the non-active area NA will be described in detail with reference to FIG. 2.

FIG. 2 is an enlarged plan view of an area X of FIG. 1. FIG. 3 is a cross-sectional view of A-A' of FIG. 2. In FIG. 2, for the convenience of illustration, the plurality of link lines 120 is illustrated with a dotted line. Further, in FIG. 2, for the convenience of illustration, hatching for the plurality of driving lines 130, the plurality of sensing signal lines 140, and the plurality of ground lines GND is omitted.

First, referring to FIG. 2, the non-active area NA may include a first non-active area NA1, a second non-active area NA2, a third non-active area NA3, and a fourth non-active area NA4 which are sequentially disposed from the active area AA in a second direction DR2. In the non-active area NA including the first non-active area NA1, the second non-active area NA2, the third non-active area NA3, and the fourth non-active area NA4, a plurality of link lines 120, a plurality of driving signal lines 130, a plurality of sensing signal lines 140, a plurality of ground lines GND, a plurality of dams DAM, and a plurality of compensation patterns 150 may be disposed.

In the non-active area NA, the plurality of driving signal lines 130 is disposed.

The plurality of driving signal lines 130 may include a plurality of first driving signal lines 131 extending in the first direction DR1 and a plurality of second driving signal lines 132 extending in the second direction DR2.

Even though it is not illustrated in the drawing, the plurality of first driving signal lines 131 extends from the pad unit to be disposed in the first non-active area NA1. For example, the plurality of first driving signal lines 131 may extend from the pad unit disposed to be adjacent to an area X. At this time, the plurality of first driving signal lines 131 may be electrically connected to the plurality of second driving signal lines 132 through contact holes of the first touch insulating layer 181 and a second touch insulating layer 182 disposed in an area overlapping the plurality of second driving signal lines 132 in the first non-active area NA1.

Referring to FIG. 3 together, the plurality of first driving signal lines 131 may include a plurality patterns 131P and a plurality of wiring lines 131L which overlaps and is connected to the plurality of patterns 131P on the plurality of patterns 131P. For example, each of the plurality of patterns 131P disposed in the first direction DR1 may overlap and be connected to one of the plurality of wiring lines 131L. Therefore, the entire top surfaces of the plurality of patterns 131P are in contact with bottom surfaces of the plurality of wiring lines 131L and may reduce a resistance of the plurality of first driving signal lines 131.

Referring to FIG. 2 again, the plurality of patterns 131P may be spaced apart from each other with the plurality of compensation patterns 150 and the plurality of second driving signal lines 132 therebetween in the first direction DR1. That is, each of the plurality of patterns 131P may be disposed in an area which does not overlap the plurality of compensation patterns 150 and the plurality of second driving signal lines 132.

The plurality of patterns 131P and the plurality of wiring lines 131L may be formed of the same material as electrodes which configure the plurality of driving electrodes TE and the plurality of sensing electrodes RE. For example, if each of the plurality of driving electrodes TE and the plurality of sensing electrodes RE is formed of a plurality of bridge electrodes and a plurality of touch electrodes on the bridge electrodes, the plurality of patterns 131P may be formed of the same material as the plurality of bridge electrodes. Further, the plurality of wiring lines 131L may be formed of the same material as the plurality of touch electrodes. For example, each of the plurality of patterns 131P and the plurality of wiring lines 131L may be a single layer or multiple layers formed of any one of molybdenum (Mo), aluminum (Al), chrome (Cr), gold (Au), titanium (Ti), nickel (Ni), neodymium (Nd), and copper (Cu) or an alloy thereof, but is not limited thereto.

Referring to FIG. 2, the second driving signal line 132 may extend from the first non-active area NA1 to the active area AA in the second direction DR2. At this time, one side of the second driving signal line 132 may be connected to the plurality of first driving signal lines 131 disposed in the first non-active area NA1 and the other side of the second driving signal line 132 may be connected to the plurality of driving electrodes TE disposed in the active area AA. Therefore, the plurality of second driving signal lines 132 may transmit a touch driving signal which is transmitted from the plurality of first driving signal lines 131 to the plurality of driving electrodes TE disposed in the active area AA.

The second driving signal line 132 may be disposed on the same layer as one layer among layers which configure the plurality of first driving signal lines 131. For example, the second driving signal line 132 may be disposed on the same layer as the plurality of patterns 131P. In the meantime, referring to FIG. 2, the second driving signal line 132 may be disposed in an area which does not overlap the plurality of patterns 131P. At this time, the second driving signal line 132 may be in contact with the plurality of wiring lines 131L of the plurality of first driving signal lines 131 through contact holes of the first touch insulating layer 181 and the second touch insulating layer 182.

In the meantime, a contact position of the second driving signal line 132 and the first driving signal line 131 may be alternately disposed in plural units. For example, contact positions of the second driving signal line 132 and the first driving signal line 131 may be alternately disposed along the first direction DR1 and/or the second direction DR2. Therefore, the contact positions of the second driving signal line 132 and the first driving signal line 131 may be dispersed without being concentrated in a specific position and degradation of a touch sensing performance due to a parasitic capacitance may be suppressed.

The plurality of link lines 120 may be disposed in the second non-active area NA2. The plurality of link lines 120 may be connected to a plurality of drivers disposed in the non-active area NA. For example, the plurality of link lines 120 may be gate link lines which are electrically connected to the gate driver to receive a gate voltage, but are not limited thereto.

The plurality of link lines 120 may extend in the first direction DR1 in the second non-active area NA2. The plurality of link lines 120 may be formed of the same material as a material which configures the plurality of transistors disposed in the active area AA. For example, the plurality of link lines 120 may be formed of the same material as the source electrodes, the drain electrodes, and the gate electrodes of the plurality of transistors disposed in the active area AA, but are not limited thereto.

In the third non-active area NA3, the plurality of ground lines GND is disposed. The plurality of ground lines GND may extend from the pad unit PAD. For example, as illustrated in FIG. 2, the plurality of ground lines GND may extend from the same pad unit PAD as the pad unit PAD to which the plurality of sensing signal lines 140 extends.

The plurality of ground lines GND may include a plurality of first ground lines GND1, a plurality of second ground lines GND2, and a plurality of third ground lines GND3.

The plurality of first ground lines GND1 may be disposed between the plurality of link lines 120 and the plurality of first sensing signal lines 141. The plurality of first ground lines GND1 may extend in the first direction DR1.

In the second direction DR2, the plurality of second ground lines GND2 and the plurality of third ground lines GND3 may be disposed between the plurality of first sensing signal lines 141 and the plurality of pad units PAD. At this time, the plurality of second ground lines GND2 and the plurality of third ground lines GND3 may be disposed in an outer periphery of the plurality of wiring lines extending from the plurality of pad units PAD. For example, the plurality of second ground lines GND2 and the plurality of third ground lines GND3 may be connected to a pad electrode which is disposed in an edge, among the plurality of pad electrodes disposed in the plurality of pad units PAD.

Even though it is not illustrated in the drawing, one end of the plurality of first ground lines GND1 extending in the first direction DR1 may be electrically connected to the plurality of second ground lines GND2 and the other ends of the plurality of first ground lines GND1 may be electrically connected to the plurality of third ground lines GND3. Therefore, the first ground line GND1, the second ground line GND2, and the third ground line GND3 may have a closed-loop shape which encloses the plurality of first sensing signal lines 141.

In the meantime, the closed loop shape formed by the first ground line GND1, the second ground line GND2, and the third ground line GND3 may be disposed in each of the first area A1, the second area A2, and the third area A3, as illustrated in FIG. 1.

In the meantime, the display apparatus 100 according to the exemplary embodiment of the present disclosure further may include a plurality of ground lines GND which encloses the plurality of driving signal lines 130. For example, the plurality of driving signal lines 130 and the plurality of ground lines GND may extend from the pad unit PAD disposed to be adjacent to the area X of the display panel PN. The plurality of ground lines GND which extends from the pad unit PAD disposed to be adjacent to the area X may have a closed loop shape which encloses the plurality of driving signal lines 130. At this time,, the plurality of ground lines GND having the closed loop shape which encloses the plurality of driving signal lines 130 may be disposed in each of the first area A1, the second area A2, and the third area A3, as illustrated in FIG. 1.

The plurality of ground lines GND may be formed by a double layer. For example, the plurality of ground lines GND may have a double layered structure formed of a first conductive layer disposed on the same layer as the plurality of patterns 131P and a second conductive layer disposed on the same layer as the plurality of wiring lines 131L. For example, each of the first conductive layer and the second conductive layer which configure the plurality of first ground lines GND1 may be a single layer or multiple layers formed of any one of molybdenum (Mo), aluminum (Al), chrome (Cr), gold (Au), titanium (Ti), nickel (Ni), neodymium (Nd), and copper (Cu) or an alloy thereof, but is not limited thereto.

In the meantime, the first conductive layer, among the plurality of conductive layers which configures the plurality of ground lines GND, may be disposed on the same layer as the plurality of patterns 131P of the first driving signal line 131 and the second sensing signal line 142. At this time, in order to suppress the short between the plurality of ground lines GND and the plurality of second sensing signal lines 142, the first conductive layer may be disposed only in an area which does not overlap the plurality of second sensing signal lines 142. For example, conductive layers disposed on the same layer as the plurality of second sensing signal lines 142, among the plurality of conductive layers which configures the plurality of first ground lines GND1 may be spaced apart from each other with the plurality of second sensing signal lines 142 therebetween.

Next, in the non-active area NA, the plurality of sensing signal lines 140 is disposed.

The plurality of sensing signal lines 140 may include a plurality of first sensing signal lines 141 extending in the first direction DR1, a plurality of second sensing signal lines 142 extending in the second direction DR2, and a plurality of third sensing signal lines 143 extending in the first direction DR1.

The plurality of first sensing signal lines 141 extends from the pad unit PAD to be disposed in the third non-active area NA3. The plurality of first sensing signal lines 141 may extend in the first direction DR1 in the third non-active area NA3.

The plurality of first sensing signal lines 141 may be formed by a double layer. For example, the plurality of first sensing signal lines 141 may have a double layered structure formed of a first conductive layer disposed on the same layer as the plurality of patterns 131P and a second conductive layer disposed on the same layer as the plurality of wiring lines 131L. For example, each of the first conductive layer and the second conductive layer which configure the plurality of first sensing signal lines 141 may be a single layer or multiple layers formed of any one of molybdenum (Mo), aluminum (Al), chrome (Cr), gold (Au), titanium (Ti), nickel (Ni), neodymium (Nd), and copper (Cu) or an alloy thereof, but is not limited thereto.

Referring to FIG. 2, the second sensing signal line 142 may extend to the active area AA in the second direction DR2 in the third non-active area NA3. At this time, one side of the second sensing signal line 142 may be connected to the plurality of first sensing signal lines 141 disposed in the third non-active area NA3 and the other side of the second sensing signal line 142 may be connected to the third signal line 143. At this time, the plurality of second sensing signal lines 142 may transmit a touch sensing signal which is transmitted from the plurality of sensing electrodes RE disposed in the active area AA to the plurality of first sensing signal lines 141 through the third sensing signal line 143.

The second sensing signal line 142 is disposed on the same layer as the plurality of patterns 131P and one layer among layers which configure the plurality of first sensing signal lines 141, that is, the first conductive layer of the first sensing signal line 141, as illustrated in FIG. 3. At this time, the second sensing signal line 142 may be a part extending from the first conductive layer of the first sensing signal line 141. That is, the second sensing signal line 142 may be electrically connected to the first conductive layer of the first sensing signal line 141 without a separate contact hole, but is not limited thereto.

In the meantime, referring to FIGS. 2 and 3, the second sensing signal line 142 may overlap the plurality of first driving signal lines 131 in the first non-active area NA1. For example, the second sensing signal line 142 may intersect the plurality of wiring lines 131L of the plurality of first driving signal lines 131. At this time, referring to FIG. 3, the second sensing signal line 142 may be spaced apart from the plurality of wiring lines 131L of the plurality of first driving signal lines 131 with the first touch insulating layer 181 and the second touch insulating layer 182 therebetween.

At this time, the first touch insulating layer 181 and the second touch insulating layer 182 may be formed of an insulating material to insulate the second sensing signal line 142 and the wiring line 131L of the first driving signal line 131. For example, the first touch insulating layer 181 may be formed of an inorganic material, such as silicon oxide (SiOx), silicon nitride (SiNx), silicon oxy nitride (SiNxOy) or aluminum oxide (AlyOz). Further, the second touch insulating layer 182 may be formed of an organic material, such as polyimide or photo acryl, but is not limited thereto.

Next, referring to FIG. 2, the plurality of third sensing signal lines 143 is disposed between the second sensing signal line 142 and the active area AA. The third sensing signal line 143 may connect between the second sensing signal line 142 and the plurality of sensing electrodes RE. At this time, the third sensing signal line 143 may include a plurality of wiring lines which extends to the active area AA and is connected in parallel. For example, one third sensing signal line 143 may include a plurality of wiring lines which is connected in parallel and is connected to the plurality of sensing electrodes RE.

The plurality of compensation patterns 150 is disposed in the first non-active area NA.

The plurality of compensation patterns 150 may be electrically connected to the plurality of sensing signal lines 140. Referring to FIG. 2, the plurality of compensation patterns 150 may extend in the first direction DR1 from the second sensing signal line 142. At this time, the plurality of compensation patterns 150 may be disposed on the same layer as the plurality of second sensing signal lines 142 and extends in the first direction DR1 from the plurality of second sensing signal lines 142.

Further, referring to FIG. 3 together, the plurality of compensation patterns 150 is disposed on the same layer as the plurality of patterns 131P of the first driving signal line 131. At this time, the plurality of compensation patterns 150 may be disposed to be spaced apart from the plurality of patterns 131P of the first driving signal line 131 on the plane.

In the meantime, referring to FIGS. 2 and 3, the plurality of compensation patterns 150 may overlap the plurality of driving signal lines 130. For example, the plurality of compensation patterns 150 may overlap the plurality of wiring lines 131L of the plurality of first driving signal lines 131. At this time, the plurality of compensation patterns 150 may be spaced apart from the plurality of wiring lines 131L of the plurality of first driving signal lines 131 with the first touch insulating layer 181 and the second touch insulating layer 182 therebetween in the third direction DR3. At this time, the first touch insulating layer 181 may cover top surfaces and side surfaces of the plurality of compensation patterns 150. Therefore, the entire top surfaces of the plurality of compensation patterns 150 are in contact with the bottom surface of the first touch insulating layer 181 and may be insulated from the first driving signal line 131 by the first touch insulating layer 181.

In the meantime, the plurality of compensation patterns 150 may form a capacitor C while overlapping the plurality of first driving signal lines 131 in the first non-active area NA1. Accordingly, in one second sensing signal line 142 which is electrically connected to the plurality of compensation patterns 150, RC load may be generated.

Referring to FIG. 2, the plurality of compensation patterns 150 connected to one second sensing signal line 142 may have the same length.

In the meantime, even though in FIG. 2, it is illustrated that the plurality of compensation patterns 150 connected to two second sensing signal lines 142 has the same length, the present disclosure is not limited thereto. For example, the plurality of compensation patterns 150 may be designed in consideration of a length of the plurality of sensing electrodes RE connected to one second sensing signal line 142. At this time, when the active area AA has an irregular structure, the plurality of sensing electrodes RE connected to the second sensing signal lines 142 may have a different length in every second sensing signal line 142. Therefore, a length of each of the plurality of compensation patterns 150 connected to one second sensing signal line 142 is the same, but may be different from a length of each of the plurality of compensation patterns 150 connected to an adjacent second sensing signal line 142.

In the meantime, as illustrated in FIG. 1, when the touch driver 160 is independently connected to each of the first area A1, the second area A2, and the third area A3, the plurality of second sensing signal lines 142 and the plurality of compensation patterns 150 disposed in each of the first area A1, the second area A2, and the third area A3 may be also independently connected to the touch driver 160. Therefore, the plurality of compensation patterns 150 disposed in the display apparatus 100 may include a plurality of compensation patterns 150 connected to different touch drivers 160.

Next, a plurality of dams DAM is disposed in the fourth non-active area NA4. The plurality of dams DAM may suppress an organic material disposed in the first non-active area NA1, the second non-active area NA2, and the third non-active area NA3 from overflowing to the outside of the plurality of dams DAM. For example, the plurality of dams DAM may suppress an organic material from overflowing toward the plurality of flexible films COF.

The plurality of dams DAM may be formed of the same material the organic material disposed in the active area AA. For example, the display apparatus 100 may include a lens which refracts light emitted from the light emitting diode on the encapsulation layer of the active area AA. At this time, the plurality of dams DAM may be formed of the same material as the lens disposed in the active area AA, but are not limited thereto.

When the active area has an irregular structure, a length of a wiring line and/or electrode disposed in the active area may vary in every position. For example, a length of a wiring line and/or electrode extending in the first direction may vary in every position and a length of wiring line and/or electrode extending in the second direction may vary in every position. Therefore, there may be a difference in the RC load applied to the wiring line and/or electrode disposed in the active area. For example, if the touch electrode is disposed in the active area having an irregular structure, the RC load may vary depending on a number and/or lengths of touch electrodes disposed in the active area. Therefore, in the display apparatus with an irregular structure, a difference in touch sensing occurs in every area and a difference in touch sensitivity may occur. Specifically, as a configuration of generating touch sensing data, the sensing electrode may react sensitively to the RC load, which may directly affect the difference in the touch sensitivity.

In the display apparatus 100 according to the exemplary embodiment of the present disclosure, a plurality of compensation patterns 150 is disposed in the display apparatus 100 with an irregular structure to compensate for RC loads of the plurality of sensing electrodes RE and the plurality of sensing signal lines 140. Specifically, the plurality of compensation patterns 150 is connected to the plurality of second sensing signal lines 142 and overlaps the plurality of first driving signal lines 131. Therefore, the plurality of compensation patterns 150 may form a capacitor C with the plurality of first driving signal lines 131. Accordingly, the plurality of compensation patterns 150 is connected to the sensing signal line 140 extending to a region of the active area AA having a shorter length in the second direction DR2 to form a capacitor C. Accordingly, a load may be generated in the sensing signal line 140 to which the plurality of compensation patterns 150 is connected and a deviation of an RC load with the sensing signal line 140 which extends to a region having a longer length in the second direction DR2 may be compensated. Accordingly, touch sensitivity irregularity is improved and touch performance is optimized.

Further, in the display apparatus 100 according to the exemplary embodiment of the present disclosure, the plurality of compensation patterns 150 is disposed so as to overlap the plurality of first driving signal lines 131 to reduce the non-active area NA. For example, when a non-active area for placing a compensation pattern is separately formed in the display apparatus, a non-active area of the display apparatus may be widened. Therefore, in the display apparatus 100 according to the exemplary embodiment of the present disclosure, the compensation pattern 150 is disposed in an area where the plurality of first driving signal lines 131 is disposed to reduce the non-active area NA.

Further, in the display apparatus 100 according to the exemplary embodiment of the present disclosure, the plurality of compensation patterns 150 is disposed on one side of the display panel PN in which the plurality of touch drivers 160 is disposed. Therefore, the plurality of sensing signal lines 140 may be connected to the plurality of sensing electrodes RE in a state in which a deviation of the RC load is improved. Therefore, as compared with the example that the plurality of compensation patterns is disposed to be spaced apart from the plurality of touch drives with an active area therebetween, the RC load deviation may be efficiently compensated.

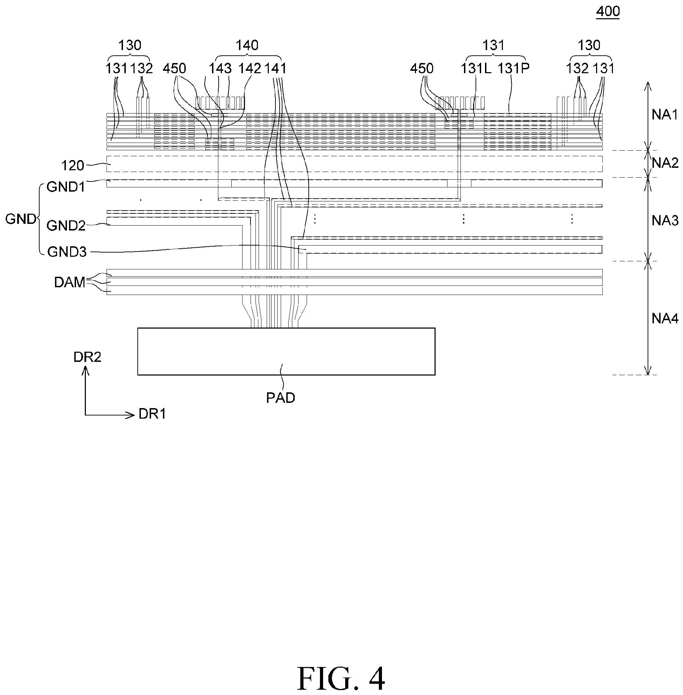

FIG. 4 is a schematic enlarged plan view of a display apparatus according to another exemplary embodiment of the present disclosure. The only difference between a display apparatus 400 of FIG. 4 and the display apparatus 100 of FIGS. 1 to 3 is a plurality of compensation patterns 450 so that a redundant description will be omitted.

Referring to FIG. 4, a plurality of compensation patterns 450 which is electrically connected to the plurality of sensing signal lines 140 is disposed in the first non-active area NA1. At this time, the plurality of compensation patterns 450 may extend from one second sensing signal line 142.

Intervals between the plurality of compensation patterns 450 connected to one second sensing signal line 142 may not be constant. For example, an interval between some compensation patterns 450, among the plurality of compensation patterns 450, in the second direction DR2 may be equal to an interval of the first driving signal lines 131. However, an interval between other compensation patterns 450, among the plurality of compensation patterns 450 may be larger than the interval of the first driving signal lines 131.

Further, the intervals between the plurality of compensation patterns 450 in the second direction DR2 may vary in each of the plurality of second sensing signal lines 142. For example, a distance between a compensation pattern 450 adjacent to the active area AA and a compensation pattern 450 adjacent to the second non-active area NA2, among the plurality of compensation patterns 450 connected to one second sensing signal line 142, may be different from a distance between a compensation pattern 450 adjacent to the active area AA and a compensation pattern 450 adjacent to the second non-active area NA2, among the plurality of compensation patterns 450 connected to the other second sensing signal line 142. For example, the compensation pattern 450 connected to one second sensing signal line 142 may be disposed to be adjacent to the second non-active area NA2 more than the compensation pattern 450 connected to the other second sensing signal line 142. Further, a minimum interval between the plurality of compensation patterns 450 and the plurality of flexible circuit film COF may vary for each of the plurality of second sensing signal lines 142.

In the display apparatus 400 according to another exemplary embodiment of the present disclosure, a plurality of compensation patterns 450 which is connected to the plurality of second sensing signal lines 142 and overlaps the plurality of first driving signal lines 131 is disposed in the display apparatus 400 having an irregular structure. Therefore, the RC load of the plurality of sensing electrodes RE and the plurality of sensing signal lines 140 is compensated.

Further, in the display apparatus 400 according to another exemplary embodiment of the present disclosure, the plurality of compensation patterns 450 is disposed so as to overlap the plurality of first driving signal lines 131 to reduce the non-active area NA.

Further, in the display apparatus 400 according to another exemplary embodiment of the present disclosure, the plurality of compensation patterns 450 is disposed on one side of the display panel PN in which the plurality of touch drivers 160 is disposed, thereby efficiently compensating for the RC load deviation.

Further, in the display apparatus 400 according to another exemplary embodiment of the present disclosure, the interval between the plurality of compensation patterns 450 in the second direction DR2 is adjusted to adjust an RC load generated in the sensing signal line 140 and/or the driving signal line 130. For example, when all the plurality of compensation patterns is spaced apart from each other with the same interval in the second direction, and all the intervals of the plurality of compensation patterns connected to the second sensing signal line are the same, an area of the driving signal line which overlaps the compensation pattern may vary for every driving signal line. For example, when all the plurality of compensation patterns is spaced apart from each other with the same interval and is adjacent to the active area between the active area and the second non-active area, more load may be generated in the first driving signal line located to be adjacent to the active area than in the first driving signal line adjacent to the second non-active area. Therefore, in the display apparatus 400 according to another exemplary embodiment of the present disclosure, the plurality of compensation patterns 450 is disposed in different positions for every second sensing signal line 142 to suppress the RC load from being concentrated locally in the driving signal line 130. Accordingly, touch sensitivity irregularity is improved and touch performance is optimized.

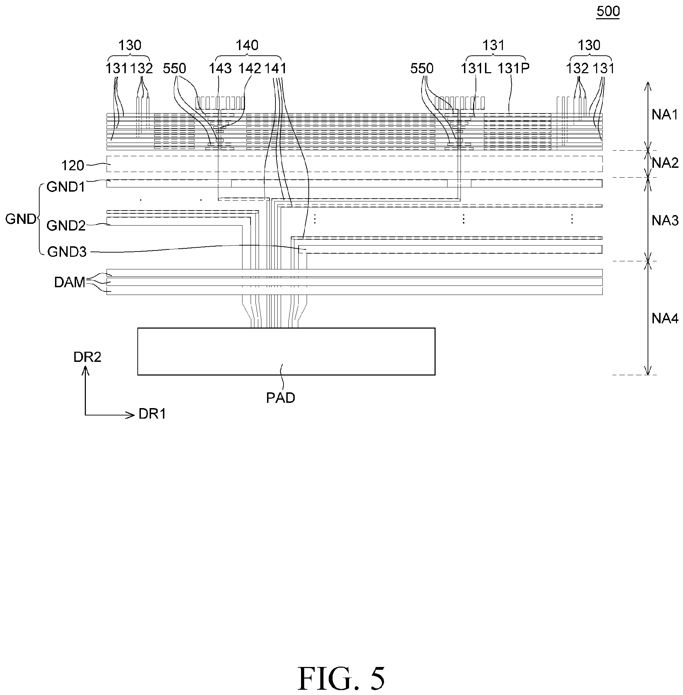

FIG. 5 is a schematic enlarged plan view of a display apparatus according to still another exemplary embodiment of the present disclosure. The only difference between a display apparatus 500 of FIG. 5 and the display apparatus 100 of FIGS. 1 to 3 is a plurality of compensation patterns 550 so that a redundant description will be omitted.

Referring to FIG. 5, a plurality of compensation patterns 550 which is electrically connected to the plurality of sensing signal lines 140 is disposed in the first non-active area NA1. The plurality of compensation patterns 550 may extend in the first direction DR1 from one second sensing signal line 142.

At this time, lengths of the plurality of compensation patterns 550 connected to one second sensing signal line 142 may not be the same. For example, all the lengths of the plurality of compensation patterns 550 in the first direction DR1 may not be the same.

At this time, lengths of the plurality of compensation patterns 550 connected to one second sensing signal line 142 may gradually change along the second direction DR2. For example, with respect to a compensation pattern 550 having a smallest length, among the plurality of compensation patterns 550, as the compensation patterns are adjacent to the active area AA, the length of the compensation pattern 550 is gradually increased. Further, as the compensation patterns is adjacent to the second non-active area NA2, the length of the compensation pattern 550 is gradually increased.

In the meantime, in FIG. 5, it is illustrated that the compensation pattern 550 having a smallest length, among the plurality of compensation patterns 550, is disposed to be adjacent to the second non-active area NA2, between the active area AA and the second non-active area NA2, but the present disclosure is not limited thereto. For example, the length of the plurality of compensation patterns 550 may vary for every second sensing signal line 142 connected to the plurality of compensation patterns 550 and may be designed in consideration of the length of the plurality of sensing electrodes **RE** connected to one second sensing signal line 142.

In the display apparatus 500 according to another exemplary embodiment of the present disclosure, a plurality of compensation patterns 550 which is connected to the plurality of second sensing signal lines 142 and overlaps the plurality of first driving signal lines 131 is disposed in the display apparatus 500 having an irregular structure. Therefore, the RC load of the plurality of sensing electrodes **RE** and the plurality of sensing signal lines 140 is compensated.

Further, in the display apparatus 500 according to another exemplary embodiment of the present disclosure, the plurality of compensation patterns 550 is disposed so as to overlap the plurality of first driving signal lines 131 to reduce the non-active area NA.

Further, in the display apparatus 500 according to another exemplary embodiment of the present disclosure, the plurality of compensation patterns 550 is disposed on one side of the display panel PN in which the plurality of touch drivers 160 is disposed, thereby efficiently compensating for the RC load deviation.

Further, in the display apparatus 500 according to another exemplary embodiment of the present disclosure, the length of the plurality of compensation patterns 550 in the second direction DR2 is adjusted to adjust an RC load generated in the sensing signal line 140 and/or the driving signal line 130. At this time, lengths of the plurality of compensation patterns 550 connected to one second sensing signal line 142 may be gradually changed. Therefore, the load generated in the second sensing signal line 142 may be gradually changed and the load generated in the first driving signal line 131 which overlaps the plurality of compensation patterns 550 may also be gradually changed. Therefore, the sharp fluctuation in the RC load deviation generated in the plurality of driving signal lines 130 and the plurality of sensing signal lines 140 is suppressed so that touch performance of the display apparatus 500 may be optimized.

The exemplary embodiments of the present disclosure can also be described as follows:

According to an aspect of the present disclosure, a display apparatus comprises a display panel including a plurality of driving electrodes and a plurality of sensing electrodes intersecting the plurality of driving electrodes, and a plurality of touch drivers which is disposed on one side of the display panel and is electrically connected to the plurality of driving electrodes and the plurality of sensing electrodes, wherein the display panel includes a plurality of driving signal lines which connects the plurality of driving electrodes and the plurality of touch drivers, a plurality of sensing signal lines which connects the plurality of sensing electrodes and the plurality of touch drivers, and a plurality of compensation patterns which overlaps the plurality of driving signal lines and extends from the plurality of sensing signal lines.

The plurality of driving signal lines may include a plurality of patterns and a plurality of wiring lines which overlaps and is connected to the plurality of patterns on the plurality of patterns and the plurality of compensation patterns is disposed on the same layer as the plurality of patterns.

The display panel may further include an insulating layer disposed on the plurality of compensation patterns, entire top surfaces of the plurality of compensation patterns may be in contact with a bottom surface of the insulating layer and entire top surfaces of the plurality of patterns may be in contact with bottom surfaces of the plurality of wiring lines.

The plurality of sensing signal lines may include a plurality of first sensing signal lines extending in a first direction and a plurality of second sensing signal lines which is connected to the plurality of first sensing signal lines and extends in a second direction and the plurality of compensation patterns may overlap a plurality of driving signal lines extending in the first direction and extends from the plurality of second sensing signal lines to the first direction.

All the lengths of the plurality of compensation patterns connected to one sensing signal line, among the plurality of sensing signal lines, may be the same.

Intervals between the plurality of compensation patterns connected to one second sensing signal line, among the plurality of sensing signal lines, may not constant.

The plurality of compensation patterns may be electrically connected to one second sensing signal line, among the plurality of second sensing signal lines and intervals between the plurality of compensation patterns in the second direction may vary for each of the plurality of second sensing signal lines.

The plurality of compensation patterns may be electrically connected to one second sensing signal line, among the plurality of second sensing signal lines and the plurality of compensation patterns which is electrically connected to one second sensing signal line may include at least one compensation pattern having a different length.

Lengths of the plurality of compensation patterns connected to one second sensing signal line may be gradually changed along the second direction.

The plurality of compensation patterns may include a compensation pattern connected to a different touch driver, among the plurality of touch drivers.

The display panel may include sides formed by a straight line and a curved line.

According to another aspect of the present disclosure, a display apparatus comprises a display panel including an active area in which a distance between a top and a bottom varies in every area and a non-active area disposed on one side of the active area, a plurality of flexible circuit films disposed in the non-active area, a plurality of driving electrodes and a plurality of sensing electrodes intersect each other on the display panel, a plurality of touch drivers which is disposed in the non-active area and is electrically connected to the plurality of driving electrodes and the plurality of sensing electrodes, a plurality of driving signal lines which connects the plurality of driving electrodes and the plurality of touch drivers, a plurality of sensing signal lines which connects the plurality of sensing electrodes and the plurality of touch drivers, and a plurality of compensation patterns which overlaps the plurality of driving signal lines in the non-active area and extends from the plurality of sensing signal lines.

The plurality of driving electrodes and the plurality of compensation patterns may extend in a first direction and the plurality of sensing electrodes and the plurality of sensing signal lines may extend in a second direction.

The plurality of driving signal lines may include a plurality of patterns which extends in the first direction and is spaced apart from each other with the plurality of sensing signal lines therebetween, and a plurality of wiring lines which is in contact with the plurality of patterns on the plurality of patterns, and the plurality of compensation patterns may be disposed on the same layer as the plurality of patterns.

The display panel may further include an insulating layer disposed on the plurality of compensation patterns, entire top surfaces of the plurality of compensation patterns may be in contact with a bottom surface of the insulating layer and entire top surfaces of the plurality of patterns may be in contact with bottom surfaces of the plurality of wiring lines.

All the lengths of the plurality of compensation patterns connected to one sensing signal line, among the plurality of sensing signal lines may be the same.

The plurality of compensation patterns may be electrically connected to one second sensing signal line, among the plurality of second sensing signal lines and minimum intervals between the plurality of flexible circuit films and the plurality of compensation patterns may vary for each of the plurality of second sensing signal lines.

The plurality of compensation patterns may be electrically connected to one second sensing signal line, among the plurality of second sensing signal lines and the plurality of compensation patterns electrically connected to one second sensing signal line may include at least one or more compensation patterns having a different length.

The plurality of compensation patterns may include a compensation pattern connected to a different touch driver, among the plurality of touch drivers.

Also disclosed are the following numbered clauses:
1. A display apparatus, comprising:
   a display panel including an active area in which a distance between a top and a bottom varies in every area and a non-active area disposed on one side of the active area;
   a plurality of flexible circuit films disposed in the non-active area;
   a plurality of driving electrodes and a plurality of sensing electrodes intersect each other on the display panel;
   a plurality of touch drivers which is disposed in the non-active area and is electrically connected to the plurality of driving electrodes and the plurality of sensing electrodes;
   a plurality of driving signal lines which connects the plurality of driving electrodes and the plurality of touch drivers;
   a plurality of sensing signal lines which connects the plurality of sensing electrodes and the plurality of touch drivers; and
   a plurality of compensation patterns which overlaps the plurality of driving signal lines in the non-active area and extends from the plurality of sensing signal lines.
2. The display apparatus according to clause 1, wherein the plurality of driving electrodes and the plurality of compensation patterns extend in a first direction and the plurality of sensing electrodes and the plurality of sensing signal lines extend in a second direction.
3. The display apparatus according to clause 1 or 2, wherein the plurality of driving signal lines includes:
   a plurality of patterns which extends in the first direction and is spaced apart from each other with the plurality of sensing signal lines therebetween; and
   a plurality of wiring lines which is in contact with the plurality of patterns on the plurality of patterns, and
   the plurality of compensation patterns is disposed on the same layer as the plurality of patterns.
4. The display apparatus according to clause 3, wherein the display panel further includes an insulating layer disposed on the plurality of compensation patterns,
   entire top surfaces of the plurality of compensation patterns are in contact with a bottom surface of the insulating layer and
   entire top surfaces of the plurality of patterns are in contact with bottom surfaces of the plurality of wiring lines.
5. The display apparatus according to any of clauses 2 to 4, wherein all the lengths of the plurality of compensation patterns connected to one sensing signal line, among the plurality of sensing signal lines, are the same.
6. The display apparatus according to any of clauses 2 to 5, wherein the plurality of compensation patterns is electrically connected to one sensing signal line, among the plurality of sensing signal lines and minimum intervals between the plurality of flexible circuit films and the plurality of compensation patterns vary for each of the plurality of sensing signal lines.
7. The display apparatus according to any of clauses 2 to 6, wherein the plurality of compensation patterns is electrically connected to one sensing signal line, among the plurality of sensing signal lines and
   the plurality of compensation patterns electrically connected to one sensing signal line includes at least two or more compensation patterns having different lengths.
8. The display apparatus according to claim any of clauses 2 to 7, wherein the plurality of compensation patterns includes compensation patterns connected to different touch drivers, among the plurality of touch drivers.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims, and all the technical concepts in the equivalent scope thereof should be construed as falling within the scope of the present disclosure.

## Claims

1. A display apparatus, comprising:
a display panel including a plurality of driving electrodes and a plurality of sensing electrodes intersecting the plurality of driving electrodes; and
a plurality of touch drivers which is disposed on one side of the display panel and is electrically connected to the plurality of driving electrodes and the plurality of sensing electrodes,
wherein the display panel includes:
a plurality of driving signal lines which connects the plurality of driving electrodes and the plurality of touch drivers;
a plurality of sensing signal lines which connects the plurality of sensing electrodes and the plurality of touch drivers; and
a plurality of compensation patterns which overlaps the plurality of driving signal lines and extends from the plurality of sensing signal lines.

2. The display apparatus according to claim 1, wherein the plurality of driving signal lines includes a plurality of patterns and a plurality of wiring lines which overlaps and is connected to the plurality of patterns on the plurality of patterns and the plurality of compensation patterns is disposed on the same layer as the plurality of patterns.

3. The display apparatus according to claim 2, wherein the display panel further includes an insulating layer disposed on the plurality of compensation patterns; entire top surfaces of the plurality of compensation patterns are in contact with a bottom surface of the insulating layer and entire top surfaces of the plurality of patterns are in contact with bottom surfaces of the plurality of wiring lines.

4. The display apparatus according to any preceding claim, wherein the plurality of sensing signal lines includes a plurality of first sensing signal lines extending in a first direction and a plurality of second sensing signal lines which is connected to the plurality of first sensing signal lines and extends in a second direction, and
the plurality of compensation patterns overlaps a plurality of driving signal lines extending in the first direction and extends from the plurality of second sensing signal lines in the first direction.

5. The display apparatus according to claim 4, wherein all the lengths of the plurality of compensation patterns connected to one second sensing signal line, among the plurality of sensing signal lines, are the same.

6. The display apparatus according to claim 4 or 5, wherein intervals between the plurality of compensation patterns connected to one second sensing signal line, among the plurality of sensing signal lines, are not constant.

7. The display apparatus according to claim 4, 5 or 6, wherein the plurality of compensation patterns is electrically connected to one second sensing signal line, among the plurality of second sensing signal lines, and
intervals between the plurality of compensation patterns in the second direction vary for each of the plurality of second sensing signal lines.

8. The display apparatus according to claim 4, 5, 6 or 7, wherein the plurality of compensation patterns is electrically connected to one second sensing signal lines, among the plurality of second sensing signal lines, and
the plurality of compensation patterns which is electrically connected to one second sensing signal line includes at least two compensation patterns having different lengths.

9. The display apparatus according to claim 8, wherein lengths of the plurality of compensation patterns connected to one second sensing signal line are gradually changed along the second direction.

10. The display apparatus according to any preceding claim, wherein the plurality of compensation patterns includes compensation patterns connected to different touch drivers, among the plurality of touch drivers.

11. The display apparatus according to any preceding claim, wherein the display panel includes sides formed by a straight line and a curved line.

12. The display apparatus according to claim 5 or any preceding claim when dependent on claim 5, wherein the length of each of the plurality of compensation patterns connected to one second sensing signal line is different from a length of each of the plurality of compensation patterns connected to an adjacent second sensing signal line.

13. The display apparatus according to claim 3 or any preceding claim when dependent on claim 5, wherein the plurality of compensation patterns is spaced apart from the plurality of wiring lines with the insulating layer therebetween in a third direction.
